# EUROPEAN PATENT APPLICATION

(11) **EP 4 726 471 A2**
(43) Date of publication of application: **15.04.2026**
(21) Application number: 26158818.0
(22) Date of filing: 16.02.2026
(51) Int. Cl.: G03F 1/44, G03F 7/00

(54) **A METHOD OF DETERMINING AN APODIZATION MODFICATION OF A FIDUCIAL FOR CHARACTERIZING A PUPIL OF AN OPTICAL SYSTEM**

(71) Applicant: ASML Netherlands B.V., 5500 AH Veldhoven (NL)
(72) Inventor: GEELEN, Paul Jean Maurice, 5500 AH Vedlhoven (NL); SCHOLTEN, Bert Dirk, 5500 AH Vedlhoven (NL); DIKKERS, Manfred Petrus Johannes Maria, 5500 AH Vedlhoven (NL); LOF, Gerrit Jan Jacob, 5500 AH Vedlhoven (NL)
(74) Representative: ASML Netherlands B.V.

(57) **Abstract**

A method of determining an apodization modification of a fiducial for characterizing a pupil of an optical system of an apparatus, the fiducial comprising a plurality of reflective areas, the method comprising obtaining an apodization characteristic of a first reflective area, wherein during nominal operation of the apparatus the first reflective area is arranged outside an illumination field of the apparatus; performing in-situ a first pupil measurement of the optical system by arranging the first reflective area within the illumination field; performing in-situ a second pupil measurement of the optical system by arranging a second reflective area of the fiducial within the illumination field, wherein during nominal operation of the apparatus the second reflective area is arranged within the illumination field; and determining the apodization modification of the fiducial based on the obtained apodization characteristic and the first and second pupil measurements.

## Description

### FIELD

The present invention relates to lithographic systems used in semiconductor manufacturing. In particular, it pertains to a method of determining an apodization modification of a fiducial for characterizing a pupil of an optical system of an apparatus, as well as an exposure apparatus comprising a processing system configured to perform the method.

### BACKGROUND

An exposure apparatus, such as a lithographic apparatus, is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

In an exposure apparatus, the radiation used to project the pattern onto the substrate is provided by an illumination system. The illumination system is configured to generate a desired angular and spatial distribution of radiation, which may be described in terms of a pupil of an optical system. The pupil defines, for example, the angular distribution of the radiation incident on the patterning device and ultimately on the substrate. Accurate characterization of the pupil is important for ensuring correct imaging performance and for calibrating and qualifying the illumination system.

Pupil characterization in an exposure apparatus may be performed using one or more fiducial structures in combination with one or more sensors. Such fiducial structures may interact with the radiation generated by the illumination system, enabling pupil-related information to be derived from signals detected by the sensors. The interaction depends on the angle of incidence of the radiation. As a result, the intensity of radiation reflected by the fiducial may vary across the pupil as a function of angle, thereby introducing apodization effects in the measured pupil.

Herein, the term 'fiducial' refers generally to an optical element (e.g., a structure, marker, target, or other reference feature) used in a measurement setup of an apparatus, for example to interact with radiation and thereby facilitate the derivation of measurement information from one or more detected signals.

Apodization effects introduced by a fiducial may cause deviations between a measured pupil and the actual pupil generated by the illumination system. Such deviations can influence derived performance metrics of the exposure apparatus. For example, inaccuracies in pupil characterization may affect the determination of imaging telecentricity, which may result in pattern placement errors on the substrate.

Apodization characteristics of fiducial structures may be determined prior to installation in the exposure apparatus using metrology tools capable of measuring reflectivity as a function of incidence angle. Such pre-characterized apodization data may be used to compensate for fiducial-induced effects during pupil measurements. However, fiducial structures may be exposed to EUV radiation and to the operating environment of the exposure apparatus, which may lead to contamination or other changes affecting their reflectivity over time. In such cases, inaccuracies in pupil characterization caused by fiducial apodization effects may have a direct impact on system performance, imaging accuracy, and calibration results.

Accordingly, there is a need for a method that enable more accurate determination of pupil characteristics of an optical system in an apparatus.

### SUMMARY

Therefore, according to an aspect of the invention there is provided a method of determining an apodization modification of a fiducial for characterizing a pupil of an optical system of an apparatus, the fiducial comprising a plurality of reflective areas, the method comprising: obtaining an apodization characteristic of a first reflective area, wherein during nominal operation of the apparatus the first reflective area is arranged outside an illumination field of the apparatus such that the first reflective area is not illuminated by radiation;
performing in-situ a first pupil measurement of the optical system by arranging the first reflective area within the illumination field;
performing in-situ a second pupil measurement of the optical system by arranging a second reflective area of the fiducial within the illumination field, wherein during nominal operation of the apparatus the second reflective area is arranged within the illumination field; and
determining the apodization modification of the fiducial based on the obtained apodization characteristic and the first and second pupil measurements.

In an embodiment, the apodization characteristic comprises reflectivity as a function of incidence angle of a radiation beam.

In an embodiment, obtaining the apodization characteristic comprises measuring the apodization characteristic ex situ.

In an embodiment, measuring the apodization characteristic comprises measuring the apodization characteristic of multiple first reflective areas arranged outside the illumination field during nominal operation.

In an embodiment, at least one reflective area, for example the first reflective area and/or the second reflective area, comprises a pinhole area.

In an embodiment, at least one reflective area, for example the first reflective area and/or the second reflective area, has a circular shape or a rectangular shape.

In an embodiment, the method further comprising moving the fiducial in a first direction parallel to a longitudinal direction of the illumination field.

In an embodiment, the method further comprising moving the fiducial in a second direction transverse to the first direction of the illumination field and parallel to the illumination field.

In an embodiment, determining the apodization modification comprises determining a difference between the first pupil measurement and the second pupil measurement as a function of pupil coordinate.

In an embodiment, the method further comprising determining the apodization modification for each reflective area of the plurality of reflective areas.

In an embodiment, the method further comprising updating the apodization characteristic of at least one reflective area that is illuminated during nominal operation based on the determined apodization modification to obtain a corrected apodization characteristic for said reflective area.

In an embodiment, the method further comprising correcting pupil data of at least one pupil measurement of the optical system using the determined apodization modification to obtain a corrected pupil measurement.

In an embodiment, the first pupil measurement and the second pupil measurement are performed using identical apparatus settings and an identical measurement position of the illumination field, such that the first pupil measurement and the second pupil measurement comprise pupil data at corresponding pupil coordinates used for determining the apodization modification.

In an embodiment, the method further comprising stitching apodization modifications determined for subsequent reflective areas to provide a stitched apodization modification dataset.

In an embodiment, the method comprising repeating the steps of performing an in-situ pupil measurement of the optical system for a subsequent reflective area arranged within the illumination field and stitching an apodization modification determined for the subsequent reflective area to the stitched apodization modification dataset, until the plurality of reflective areas are included in the stitched apodization modification dataset.

In an embodiment, the method further comprising validating the apodization modification by:
obtaining an apodization characteristic of a third reflective area arranged outside the illumination field of the apparatus during nominal operation; and
comparing the obtained apodization characteristic of the third reflective area with an apodization value for the third reflective area predicted by the stitched apodization modification dataset.

In an embodiment, the fiducial is comprised within an exposure apparatus, a lithographic apparatus, an inspection apparatus or a metrology apparatus.

According to an aspect of the invention, there is provided a computer program comprising program instructions configured to cause a processing system to perform the method of the invention when the program is executed by the processing system.

According to an aspect of the invention, there is provided a processing system comprising a processor and a storage device, the storage device comprising the computer program of the invention.

According to an aspect of the invention, there is provided a metrology, inspection and/or sensor apparatus comprising the processing system of the invention.

In an embodiment, the metrology, inspection and/or sensor apparatus comprises a transmission image sensor, a wavefront sensor, a level sensor, an alignment sensor and/or a sensor for aligning a first object support to a second object support.

According to an aspect of the invention, there is provided an exposure apparatus comprising the processing system of the invention.

According to an aspect of the invention, there is provided an exposure apparatus comprising the metrology, inspection and/or sensor apparatus of the invention.

In an embodiment, the exposure appartus further comprising:
a patterning device support for supporting a patterning device;
projection optics for projecting a pattern onto the patterning device; and
at least one substrate support for supporting a substrate.

According to an aspect of the invention, there is provided an exposure apparatus having a processing system configured to perform the method of the invention.

Further features of the disclosure, as well as the structure and operation of various embodiments of the disclosure, are described in detail below with reference to the accompanying drawings. It is noted that the disclosure is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

The accompanying drawings, which are incorporated herein and form part of the specification, illustrate the present disclosure and, together with the description, further serve to explain the principles of the disclosure and to enable a person skilled in the relevant art(s) to make and use the disclosure. Embodiments of the present disclosure will now be described, by way of example only, with reference to the accompanying schematic drawings, in which:
Figure 1 depicts a lithographic system comprising a lithographic apparatus and a radiation source;
Figure 2 depicts a schematic illustration of a method of determining an apodization modification of a fiducial for characterizing a pupil of an optical system of an apparatus;
Figure 3a depicts a schematic illustration of a metrology system for performing a pupil measurement, and Figure 3b depicts a schematic illustration of a fiducial used in the pupil measurement.

The features of the present disclosure will become more apparent from the detailed description set forth below when taken in conjunction with the drawings, in which like reference characters identify corresponding elements throughout. In the drawings, like reference numbers generally indicate identical, functionally similar, and/or structurally similar elements. Additionally, generally, the left-most digit(s) of a reference number identifies the drawing in which the reference number first appears. Unless otherwise indicated, the drawings provided throughout the disclosure should not be interpreted as to-scale drawings.

### DETAILED DESCRIPTION

The invention will be explained in more detail below with reference to drawings in which illustrative embodiments thereof are shown. The drawings are intended exclusively for illustrative purposes and not as a restriction of the inventive concept which is to cover all modifications, equivalents, and alternatives falling within the scope of the present invention. The scope of the invention is only limited by the definitions presented in the appended claims.

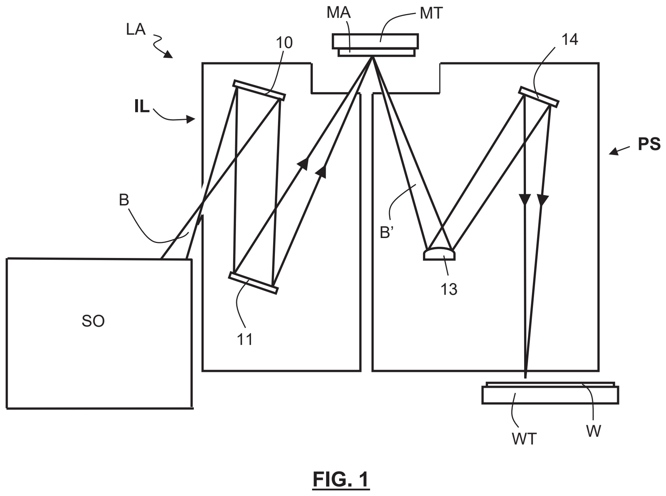

Fig. 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Fig. 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning device MA may be a mask or reticle, which imparts a pattern to a radiation beam transmitted or reflected by the patterning device. Well-known modes of operation include a stepping mode and a scanning mode. As is well known, the projection system PS may cooperate with support and positioning systems for the substrate W and the patterning device MA in a variety of ways to apply a desired pattern to many target portions across the substrate W. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The depicted apparatus could be used in a variety of modes. In a scan mode, the patterning device support (e.g., mask table) MT and the substrate table WT are scanned synchronously while a pattern imparted to the radiation beam is projected onto a target portion (i.e., a single dynamic exposure). A direction in which the patterning device MA is scanned is called a scanning direction. The speed and direction of the substrate table WT relative to the patterning device support (e.g., mask table) MT may be determined by the (de-)magnification and image reversal characteristics of the projection system PS. In the scan mode, a maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In step mode, the patterning device support MT and the substrate table WT are kept essentially stationary, while an entire pattern imparted to the radiation beam B is projected onto a target portion at one time (i.e., a single static exposure). The substrate table WT is then shifted in a X and/or Y direction so that a different target portion may be exposed.

Combinations and/or variations on the above described modes of use or entirely different modes of use may also be employed. For example, in a step-and-scan mode an area that receives light at any point in time is smaller than the full field. This area is called a slit as described below. During the exposure process, both the substrate W and the patterning device MA are moved (at a substantially constant speed). The patterning device MA is scanned such that each portion of the pattern, corresponding to a size of the slit, gets sequentially illuminated. The reflected radiation from the patterning device MA is directed to the substrate W which is moved in synchronism to project the illuminated portion of the pattern at a correct location on the substrate W.

The largest area which can be exposed in a single exposure of a lithographic apparatus is defined by its scanning field area. The illumination system IL may comprise an illumination slit which determines the scanning field area, i.e. an illuminated area of the patterning device MA per a single scan. This is defined by a width of the illumination slit in the scanning direction (often designated as an X-direction) and the maximum scan length in the orthogonal direction (the non-scanning direction, often designated as a Y-direction) of the same plane (in short, the orthogonal direction Y). In some cases, the die area (the substrate area of the device being manufactured, referred to herein as the substrate field area or substrate region area) is larger than the maximum scanning field area. In this situation, some or all layers of the device need to be exposed on the substrate region (or substrate field) in multiple (e.g., two) separate adjacent exposures. For example: a substrate region twice as large as the maximum scanning field area may be exposed in two exposures: a first exposure using a first reticle comprising a first pattern is used to print a first substrate sub-region (e.g., first half in terms of area on the substrate) of the layer, and a second reticle comprising a second pattern is used to print a second sub-region of the layer (e.g., the second half) on the substrate, adjacent the first half therefore forming the complete layer. The two halves can be referred to as having been "stitched" together, with the process sometimes referred to as intra-die stitching.

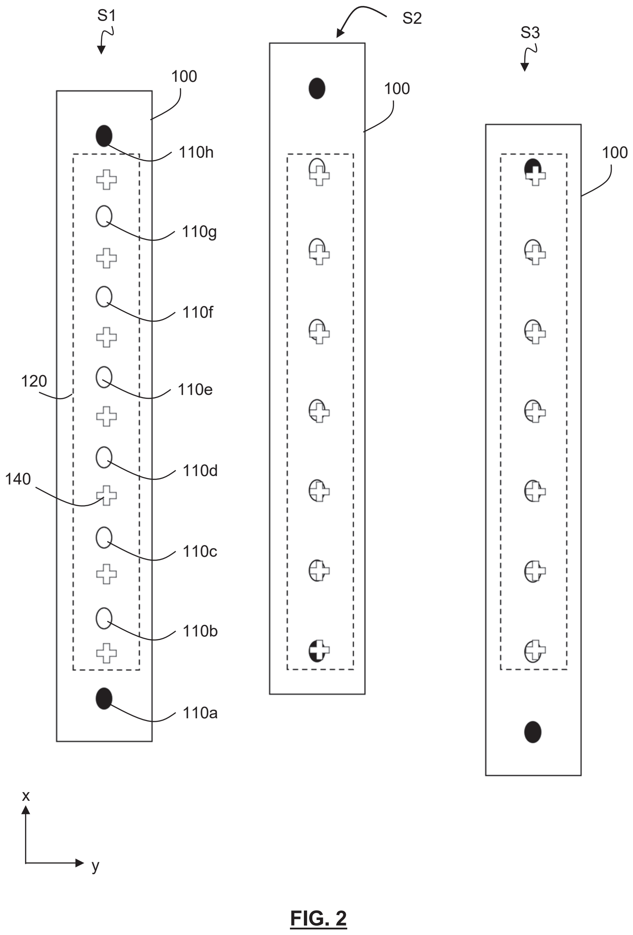

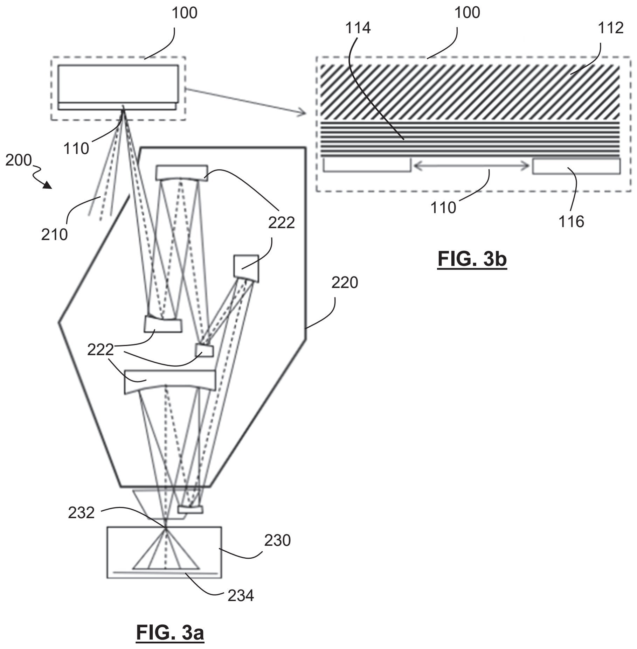

Figure 2 depicts a schematic illustration of a method of determining an apodization modification of a fiducial 100 for characterizing a pupil of an optical system of an apparatus. The pupil of the optical system represents an angular distribution of radiation transmitted by an illumination system and defines, for example, the range of propagation angles of radiation that contributes to imaging at a target plane of the apparatus. Accurate characterization of the pupil is important for assessing and calibrating performance of the optical system. The fiducial 100 is a reference structure configured to interact with radiation provided by the illumination system of the apparatus in order to enable pupil characterization (see also Figs. 3a-3b). The fiducial 100 may be arranged at a reference plane of the apparatus, for example at a plane corresponding to a patterning device plane. The fiducial 100 is distinct from a patterning device, such as a reticle, that carries an exposure pattern to be transferred to a substrate. The fiducial 100 comprises a plurality of reflective areas 110a-110h arranged at different positions on the fiducial 100, each reflective area being configured to reflect incident radiation, for example towards a pupil sensor of the apparatus to facilitate pupil measurements.

In the illustrated example, the fiducial 100 has an elongate shape and comprises eight reflective areas 110a-110h distributed along a longitudinal direction X. Each reflective area 110a-110h comprises a pinhole, which have a circular shape. Although other shapes such as rectangular shapes are also possible. The pinholes are configured to locally reflect radiation.

An illumination field 120 of the apparatus is schematically indicated by a dashed rectangular box. The illumination field 120 extends in the longitudinal direction X and has a limited extent in a transverse direction Y, transverse to the longitudinal direction X. During nominal operation of the apparatus, only reflective areas that are positioned within the illumination field 120 are illuminated by radiation. Reflective areas arranged outside the illumination field 120 during nominal operation are not illuminated and therefore do not experience radiation-induced effects such as contamination or aging. In particular, illumination of a reflective area by EUV radiation may promote the formation and/or growth of contamination layers on exposed surfaces. For example, residual hydrocarbons present in the vacuum environment can be dissociated under EUV irradiation, resulting in deposition of carbon-containing material (e.g. a carbon film) on the reflective area. Such contamination is typically not spatially uniform across the illumination field 120. Instead, the contamination rate and/or contamination layer thickness may exhibit gradients across the illumination field 120 (e.g. along X and/or Y), for example due to a non-uniform intensity distribution and/or angular-dependent exposure. Consequently, reflective areas located at different positions within the illumination field 120 may experience different contamination built-up and therefore may develop different apodization changes over time. Such a contamination layer can change the angular-dependent reflectivity of the reflective area and thus alter its apodization behavior over time. Additionally or alternatively, EUV exposure may induce surface modification or oxidation effects depending on the local environment and materials. Accordingly, reflective areas that are repeatedly illuminated during nominal operation may exhibit apodization characteristics that evolve relative to reflective areas that remain outside the illumination field 120 during nominal operation.

In the example shown in the left-hand part of Figure 2, two first reflective areas 110a, 110h, indicated by the filled circle-like symbols, are arranged outside the illumination field 120 during nominal operation. These first reflective areas 110a, 110h may function as reference reflective areas, because they are not illuminated during nominal operation and therefore are not affected by radiation-induced changes such as contamination or aging.

In a first step S1 of the method, an apodization characteristic of at least one of these first reflective areas 110a, 110h is obtained. The apodization characteristic may comprise, for example, reflectivity as a function of incidence angle of a radiation beam. The apodization characteristic may be obtained by an ex situ measurement performed prior to installation of the fiducial 100 in the apparatus. Such an ex situ measurement may be performed using a metrology tool configured to illuminate the reflective area with radiation under a plurality of controlled incidence angles corresponding to pupil coordinates of the optical system. For example, the metrology tool may sequentially vary the angle of incidence of the radiation beam relative to a surface normal of the reflective area and measure a reflected intensity for each incidence angle. The measured reflected intensity may then be normalized to obtain an angular reflectivity distribution representative of the apodization behavior of the reflective area. The apodization characteristic may be stored as a dataset associating reflectivity values with corresponding incidence angles and may be provided as input data. As explained further below, the apodization characteristic obtained for the first reflective areas 110a, 110h is used as a reference for determining an apodization modification associated with one or more reflective areas 110b-110g that are illuminated during nominal operation.

In a second step S2, illustrated in the middle part of Figure 2, the fiducial 100 is moved relative to the illumination field 120 in the positive longitudinal direction X, wherein one of the first reflective areas 110a is arranged within the illumination field 120. An in-situ first pupil measurement of the optical system 200 is then performed. During this in-situ pupil measurement, radiation from the illumination system is incident on the exposed reflective areas and radiation reflected by the exposed reflective areas is detected, e.g. by a pupil detector of the apparatus, to acquire pupil data. The cross-like symbols 140 schematically indicate a set of measurement locations or sampling points used to acquire the pupil data. In the illustrated example, these measurement locations 140 correspond approximately to locations of the exposed reflective areas 110a-110g when those reflective areas are brought into the illumination field 120, such that pupil measurements can be performed for a plurality of reflective areas at substantially corresponding sampling points. In the configuration shown, the illumination field 120 covers seven reflective areas 110a-110g. During the first pupil measurement, these seven reflective areas 110a-110g that fall within the illumination field 120 may be illuminated and measured sequentially (i.e.. one reflective area at a time), such that pupil data is acquired for each of the seven reflective areas at a corresponding measurement location 140. The first pupil measurement is performed at a defined measurement position of the illumination field 120 (e.g., a defined location and orientation of the illumination field relative to the fiducial) and with defined apparatus settings (e.g., applying an illumination mode by selecting a pupil shape such as dipole X or dipole Y). By using fixed apparatus settings and a fixed measurement position, the pupil data obtained for different reflective areas is directly comparable at corresponding pupil coordinates.

In a third step S3, illustrated in the right-hand part of Figure 2, the fiducial 100 is moved relative to the illumination field 120 in the negative longitudinal direction X, such that a second reflective area of the fiducial 100, selected from the reflective areas 110b-110g (indicated by the unfilled circle-like symbols), is arranged within the illumination field 120. During nominal operation of the apparatus, the reflective areas 110b-110g are arranged within the illumination field 120 and are illuminated by radiation.. An in-situ second pupil measurement of the optical system is performed using identical apparatus settings and the same measurement position of the illumination field 120 as used for the first pupil measurement. As in the second step, the illumination field 120 again covers seven reflective areas 110b-110h. These reflective areas 110b-110h falling within the illumination field 120 are illuminated and measured sequentially, thereby acquiring pupil data for these reflective areas under identical apparatus settings and measurement position. By shifting the fiducial 100, different reflective areas are brought into the illumination field 120, enabling comparison of pupil data of a reflective area that is nominally unexposed (i.e. the first reflective areas 110a, 110h) with pupil data of one or more reflective areas that are nominally exposed during operation (i.e. the second reflective areas 110b-110g).

An apodization modification of the fiducial 100 is determined based on the obtained apodization characteristic and the first and second pupil measurements. In particular, the apodization modification may be determined by determining a difference between the first pupil measurement and the second pupil measurement as a function of pupil coordinate. The pupil coordinate may correspond, for example, to a position in a pupil plane of the optical system. In some embodiments, the pupil data comprises a pupil intensity distribution measured over a plurality of pupil coordinates. The apodization modification may then be derived by subtracting, dividing, or otherwise comparing the pupil intensity values obtained for corresponding pupil coordinates in the first and second pupil measurements. For example, the apodization modification may represent a relative change in reflectivity or transmission as a function of pupil coordinate between the first reflective area and the second reflective area. In other embodiments, the pupil data may additionally or alternatively comprise phase-related pupil information, and the apodization modification may capture corresponding changes in phase-dependent apodization effects. Because the first and second pupil measurements are performed using identical apparatus settings and the same measurement position of the illumination field 120, differences between the two pupil measurements can be attributed to differences in the apodization behavior of the respective reflective areas, rather than to variations in the optical system or illumination conditions. As the first reflective area is associated with a known apodization characteristic, the determined difference provides an estimate of an apodization modification associated with a second reflective area, for example due to radiation-induced contamination, aging, or other changes affecting the reflective properties of that reflective area during operation of the apparatus.

The determined apodization modification may be stored as apodization modification data, for example as a correction dataset that provides, for each pupil coordinate, a correction value representative of a difference and/or ratio between the first and second pupil measurements. In subsequent processing, the method may comprise updating an apodization characteristic of at least one reflective area that is illuminated during nominal operation based on the determined apodization modification to obtain a corrected apodization characteristic for that reflective area. For example, an initially obtained apodization characteristic for the reflective area may be modified by applying the determined apodization modification as a correction factor per pupil coordinate. Additionally or alternatively, the method may comprise correcting pupil data of at least one pupil measurement of the optical system using the determined apodization modification to obtain a corrected pupil measurement, for example by applying the correction dataset to pupil intensity values or other pupil data at corresponding pupil coordinates to compensate for fiducial-induced apodization effects.

The steps illustrated in Figure 2 may be repeated for subsequent reflective areas of the fiducial 100 by further moving the fiducial 100 relative to the illumination field 120. The movement may be performed, for example, in the longitudinal direction X and/or in a transverse direction Y, such that the reflective areas of the plurality of reflective areas are sequentially arranged within the illumination field 120. For each subsequent reflective area that is arranged within the illumination field 120 (for example, for each selected second reflective area of the plurality of reflective areas 110b-1 10g), an in-situ pupil measurement of the optical system may be performed using identical apparatus settings and an identical measurement position of the illumination field 120, thereby enabling determination of a corresponding apodization modification for that subsequent reflective area.

The method may further comprise stitching apodization modifications determined for subsequent reflective areas to provide a stitched apodization modification dataset. In particular, the method may comprise repeating performing an in-situ pupil measurement of the optical system for a subsequent reflective area arranged within the illumination field 120, determining an apodization modification for that subsequent reflective area, and stitching the apodization modification determined for the subsequent reflective area to the stitched apodization modification dataset, until the plurality of reflective areas are included in the stitched apodization modification dataset.

In some embodiments, stitching comprises combining apodization modifications associated with different reflective areas into a dataset that maps apodization modification as a function of reflective-area position on the fiducial and pupil coordinate. The stitching may include, for example, registering the apodization modifications at corresponding pupil coordinates (e.g., based on the measurement locations 140). Optionally, the apodization modifications are normalised to a common reference level. Optionally, interpolation is applied between adjacent reflective areas. Where apodization modifications determined for adjacent reflective areas provide overlap in pupil coordinates and/or sampling points, the stitching may further comprise enforcing consistency in the overlap region, for example by weighted averaging or least-squares fitting, thereby generating a robust stitched apodization modification dataset.

Optionally, an apodization characteristic of a third reflective area arranged outside the illumination field 120 during nominal operation may be obtained and compared with an apodization value predicted for that reflective area by the stitched apodization modification dataset, thereby providing a validation of the determined apodization modification. For example, the stitched apodization modification dataset may predict an apodization characteristic for the third reflective area by interpolation of stitched modifications across the fiducial 100. A comparison between the obtained apodization characteristic for the third reflective area and the predicted apodization value may be used to determine a residual error. Additionally, it may be assessed whether the stitched apodization modification dataset is consistent across the fiducial 100. Additionally or alternatively, it is determined whether additional pupil measurements are desirable.

Figure 3a schematically illustrates an example of a metrology system 200 configured to perform a pupil measurement of an optical system of an apparatus, such as an exposure, inspection, or metrology apparatus. The metrology system 200 is configured to characterize a pupil of the optical system by measuring an angular intensity distribution of radiation transmitted through the optical system.

Radiation 210, for example EUV radiation, is provided by an illumination system of the apparatus (not shown in Figure 3a). The illumination system is configured to direct radiation to a fiducial 100 (see Fig. 2), such that the radiation 210 reflects on a selected reflective area 110 of the fiducial 100. The illumination system may be configured to provide radiation 210 with a defined angular distribution, wherein different propagation angles of the radiation 210 correspond to different pupil coordinates of the optical system.

As shown in Fig. 3b, the fiducial 100 comprises a substrate 112 and a reflective multilayer stack 114 that is configured to reflect radiation at an operational wavelength of the apparatus, for example EUV radiation. In some embodiments, the reflective multilayer stack 114 comprises a Mo/Si multilayer, optionally provided with a capping layer such as ruthenium. An absorber layer 116 is provided on the reflective multilayer stack 114. The absorber layer 116 may comprise an EUV-absorbing material, for example a tantalum-based absorber such as TaBN, TaBNO and/or TaNO. The absorber layer 116 may be configured to attenuate incident radiation so as to suppress reflections from regions covered by the absorber layer 116.

The reflective area 110 of the fiducial 100 is formed by locally removing the absorber layer 116, thereby exposing the underlying reflective multilayer stack 114. In this way, the exposed region defines the reflective area 110 which may function as a pinhole (also referred to as reflective pinholes). The reflective area 110 may have a defined lateral size and shape (e.g., circular or rectangular), while the surrounding absorber layer 116 provides high contrast by strongly reducing reflected intensity from adjacent regions.

Referring back to Fig. 3a, radiation reflected from the reflective area 110 of the fiducial 100 is directed into a projection optics system 220, which comprises a plurality of reflective optical elements 222, such as mirrors, arranged to guide and condition the radiation. The projection optics system 220 images the reflective area 110 and transfers angular information of the radiation to a downstream pupil measurement location. In particular, radiation reflected from the reflective area 110 at different angles propagate through different paths within the projection optics system 220, such that the angular distribution of the radiation is mapped to spatial positions at a pupil plane of the optical system.

The projection optics system 220 directs the radiation toward a pupil sensing assembly 230. The pupil sensing assembly 230 may comprise a sensor 232 having a pinhole or aperture, arranged in or near an output plane of the projection optics system 220, and a detector 234, such as a camera, arranged downstream of the sensor 232. The detector 234 may be arranged out of focus with respect to the sensor 232, such that radiation passing through the sensor 232 forms an intensity distribution on the detector 234 that is representative of the angular distribution of the radiation in the pupil plane.

In operation, radiation 210 reflected from the reflective area 110 of the fiducial 100 converges toward the sensor 232 after passing through the projection optics system 220. Radiation components corresponding to different incident angles at the fiducial 100 pass through the sensor 232 at different positions and/or directions and are subsequently detected by the detector 234. The detector 234 measures an intensity distribution, which represents a pupil image of the optical system. The measured intensity distribution thus provides pupil data describing how radiation intensity is distributed across the pupil as a function of pupil coordinate.

The measured pupil data may be processed to characterize properties of the pupil of the optical system, such as apodization. Because the measured pupil data depends on the reflective properties of the selected reflective area 110 of the fiducial 100, variations in reflectivity as a function of angle (i.e., apodization effects) of the reflective area 110 influence the measured pupil image. As described with reference to Figure 2, comparing pupil measurements performed using different reflective areas of the fiducial enables determination of apodization modifications associated with those reflective areas and correction of pupil data accordingly.

The metrology system 200 illustrated in Figure 3a may be used in combination with the method described with reference to Figure 2 to perform in-situ pupil measurements using a plurality of reflective areas of the fiducial 100.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of determining an apodization modification of a fiducial for characterizing a pupil of an optical system of an apparatus, the fiducial comprising a plurality of reflective areas, the method comprising:
obtaining an apodization characteristic of a first reflective area, wherein during nominal operation of the apparatus the first reflective area is arranged outside an illumination field of the apparatus such that the first reflective area is not illuminated by radiation;
performing in-situ a first pupil measurement of the optical system by arranging the first reflective area within the illumination field;
performing in-situ a second pupil measurement of the optical system by arranging a second reflective area of the fiducial within the illumination field, wherein during nominal operation of the apparatus the second reflective area is arranged within the illumination field; and
determining the apodization modification of the fiducial based on the obtained apodization characteristic and the first and second pupil measurements.

2. The method of claim 1, wherein the apodization characteristic comprises reflectivity as a function of incidence angle of a radiation beam.

3. The method of any preceding claim, wherein obtaining the apodization characteristic comprises measuring the apodization characteristic ex situ.

4. The method of claim 3, wherein measuring the apodization characteristic comprises measuring the apodization characteristic of multiple first reflective areas arranged outside the illumination field during nominal operation.

5. The method of any preceding claim, wherein at least one reflective area, for example the first reflective area and/or the second reflective area, comprises a pinhole area.

6. The method of any preceding claim, wherein at least one reflective area, for example the first reflective area and/or the second reflective area, has a circular shape or a rectangular shape.

7. The method of any preceding claim, further comprising moving the fiducial in a first direction parallel to a longitudinal direction of the illumination field.

8. The method of claim 7, further comprising moving the fiducial in a second direction transverse to the first direction of the illumination field and parallel to the illumination field.

9. The method of any preceding claim, wherein determining the apodization modification comprises determining a difference between the first pupil measurement and the second pupil measurement as a function of pupil coordinate.

10. The method of any preceding claim, further comprising determining the apodization modification for each reflective area of the plurality of reflective areas.

11. The method of any preceding claim, further comprising updating the apodization characteristic of at least one reflective area that is illuminated during nominal operation based on the determined apodization modification to obtain a corrected apodization characteristic for said reflective area.

12. The method of any preceding claim, further comprising correcting pupil data of at least one pupil measurement of the optical system using the determined apodization modification to obtain a corrected pupil measurement.

13. The method of any preceding claim, wherein the first pupil measurement and the second pupil measurement are performed using identical apparatus settings and an identical measurement position of the illumination field, such that the first pupil measurement and the second pupil measurement comprise pupil data at corresponding pupil coordinates used for determining the apodization modification.

14. The method of claim 13, further comprising stitching apodization modifications determined for subsequent reflective areas to provide a stitched apodization modification dataset.

15. The method of claim 14, comprising repeating the steps of performing an in-situ pupil measurement of the optical system for a subsequent reflective area arranged within the illumination field and stitching an apodization modification determined for the subsequent reflective area to the stitched apodization modification dataset, until the plurality of reflective areas are included in the stitched apodization modification dataset.

16. The method of claim 14 or claim 15, further comprising validating the apodization modification by:
obtaining an apodization characteristic of a third reflective area arranged outside the illumination field of the apparatus during nominal operation; and
comparing the obtained apodization characteristic of the third reflective area with an apodization value for the third reflective area predicted by the stitched apodization modification dataset.

17. The method of any preceding claim, wherein the fiducial is comprised within an exposure apparatus, a lithographic apparatus, an inspection apparatus or a metrology apparatus.

18. A computer program comprising program instructions configured to cause a processing system to perform the method of any one of claims 1-17 when the program is executed by the processing system.

19. A processing system comprising a processor and a storage device, the storage device comprising the computer program of claim 18.

20. A metrology, inspection and/or sensor apparatus comprising the processing system of claim 19.

21. The metrology, inspection and/or sensor apparatus of claim 20, comprising a transmission image sensor, a wavefront sensor, a level sensor, an alignment sensor and/or a sensor for aligning a first object support to a second object support.

22. An exposure apparatus comprising the processing system of claim 19.

23. An exposure apparatus comprising the metrology, inspection and/or sensor apparatus of claim 20 or 21.

24. The exposure apparatus of claim 22 or 23, further comprising:
a patterning device support for supporting a patterning device;
projection optics for projecting a pattern onto the patterning device; and
at least one substrate support for supporting a substrate.

25. An exposure apparatus having a processing system configured to perform the method of claim 1.
